# FASCICULE DE BREVET EUROPEEN

(11) **EP 3 503 104 B1**
(45) Date de publication et mention de la délivrance du brevet: **24.02.2021**
(21) Numéro de dépôt: 18213224.1
(22) Date de dépôt: 17.12.2018
(51) Int. Cl.: G11C 7/10, G11C 11/417, G11C 11/419, G11C 11/412

(54) **CIRCUIT MÉMOIRE ADAPTÉ À METTRE EN OEUVRE DES OPÉRATIONS DE CALCUL**
ADAPTIERTER SPEICHERSCHALTKREIS ZUR DURCHFÜHRUNG VON RECHENOPERATIONEN
MEMORY CIRCUIT SUITABLE FOR PERFORMING COMPUTING OPERATIONS

(30) Priorité: 19.12.2017 FR 1762534
(43) Date de publication de la demande: 26.06.2019
(73) Titulaire: Commissariat à l'Energie Atomique et aux Energies Alternatives, 75015 Paris (FR)
(72) Inventeur: Noel, Jean-Philippe, 38320 EYBENS (FR); Giraud, Bastien, 38340 VOREPPE (FR)
(74) Mandataire: Cabinet Beaumont

(56) Documents cités:
- EP-A1- 3 252 774
- US-A1- 2009 141 537
- US-A1- 2016 189 769
- AKYEL KAYA CAN ET AL: "DRC2: Dynamically Reconfigurable Computing Circuit based on memory architecture", 2016 IEEE INTERNATIONAL CONFERENCE ON REBOOTING COMPUTING (ICRC), IEEE, 17 octobre 2016 (2016-10-17), pages 1-8, XP032998975, DOI: 10.1109/ICRC.2016.7738698

## Description

### Domaine

La présente demande concerne le domaine des circuits mémoire. Elle vise plus particulièrement un circuit mémoire adapté à mettre en oeuvre des opérations de calcul.

### Exposé de l'art antérieur

Il a déjà été proposé, dans la demande de brevet français N°16/54623 déposée par le demandeur le 24 mai 2016 et dans la demande de brevet européen correspondante EP3252774, un circuit mémoire adapté non seulement à stocker des données, mais aussi à effectuer, in-situ, lors d'accès au contenu de la mémoire, un certain nombre d'opérations logiques et/ou arithmétiques ayant pour opérandes des données stockées dans la mémoire. Ce circuit comprend, comme dans un circuit mémoire classique, une pluralité de cellules élémentaires agencées en matrice selon des rangées et des colonnes, et un circuit de contrôle adapté à mettre en oeuvre des opérations de lecture ou d'écriture de données dans des rangées ou des portions de rangées de la matrice. A la différence d'un circuit mémoire classique dans lequel une seule rangée de la matrice peut être sélectionnée à la fois lors d'une opération de lecture (et d'écriture), le circuit de contrôle est adapté à sélectionner simultanément en lecture une pluralité de rangées de la matrice de façon à réaliser une opération logique ayant pour opérandes les données contenues dans les rangées sélectionnées.

Un problème qui se pose dans un tel circuit mémoire est celui de l'adressage des données opérandes lors de la mise en oeuvre d'une opération de calcul. En effet, dans un circuit mémoire classique de N rangées, où N est un entier supérieur ou égal à 2, le circuit de contrôle comprend généralement un décodeur d'adresse de rangée unique adapté à recevoir une adresse codée sur log₂(N) bits (par exemple sur 10 bits pour une mémoire de 1024 rangées), et à activer la rangée correspondante en vue d'une opération de lecture (ou d'écriture) dans cette rangée. Pour permettre d'activer simultanément en lecture K rangées distinctes de la matrice de façon à réaliser une opération logique à K opérandes, où K est un entier supérieur ou égal à 2, une possibilité serait de répliquer K fois le décodeur d'adresse de rangée, de façon à pouvoir transmettre simultanément les K adresses d'opérandes au circuit de contrôle lors de la mise en oeuvre d'une opération de calcul. Cette solution implique toutefois une augmentation importante de la surface et de la consommation énergétique du circuit, notamment lorsque le nombre K d'opérandes que l'on souhaite pouvoir traiter simultanément est important.

Les documents XP32998975 (article intitulé "DRC 2 : Dynamically Reconfigurable Computing Circuit" de Kaya Can Akyel et al.), EP3252774A1 et US2009/141537 décrivent des exemples de circuits mémoires adaptés à mettre en oeuvre des opérations de calcul.

### Résumé

Ainsi, un mode de réalisation prévoit un circuit mémoire comportant une pluralité de cellules élémentaires agencées en matrice selon des rangées et des colonnes, et un circuit de contrôle,
dans lequel chaque cellule élémentaire comporte :
un premier noeud de stockage d'un bit de donnée ;
un premier transistor reliant le premier noeud de stockage à une première piste conductrice et ayant sa grille reliée à une deuxième piste conductrice ; et
des deuxième et troisième transistors reliés en série entre un premier noeud d'application d'un potentiel de référence et une troisième piste conductrice, la grille du deuxième transistor étant reliée au premier noeud de stockage et la grille du troisième transistor étant reliée à une quatrième piste conductrice,
dans lequel les cellules élémentaires d'une même rangée sont reliées par leurs deuxièmes et troisièmes pistes conductrices et les cellules d'une même colonne sont reliées par leurs premières et quatrièmes pistes conductrices,
et dans lequel le circuit de contrôle est adapté à mettre en oeuvre une opération de lecture verticale d'un mot dans une colonne de la matrice, comprenant :
   l'application d'un signal de commande à l'état passant du troisième transistor sur la quatrième piste conductrice de la colonne contenant le mot à lire ; et
   la lecture des bits du mot sur les troisièmes pistes conductrices des rangées contenant le mot à lire ;
   et dans lequel le circuit de contrôle est en outre adapté à mettre en oeuvre une opération de lecture horizontale d'un mot dans une rangée de la matrice, comprenant :
   l'application d'un signal de commande à l'état passant du premier transistor sur la deuxième piste conductrice de la rangée contenant le mot à lire ; et
   la lecture des bits du mot sur les premières pistes conductrices des colonnes contenant le mot à lire.

Selon un mode de réalisation, le circuit de contrôle est en outre adapté à mettre en oeuvre une opération logique à plusieurs opérandes stockés dans des colonnes distinctes, comprenant :
l'application simultanée d'un signal de commande à l'état passant du troisième transistor sur les quatrièmes pistes conductrices des colonnes contenant les opérandes ;
la lecture, sur les troisièmes pistes conductrices des rangées contenant les opérandes, des bits du résultat de l'opération logique.

Selon un mode de réalisation, le circuit de contrôle est adapté, lors de la mise en oeuvre de l'opération logique, à réaliser une opération initiale de lecture horizontale d'un mot de sélection d'opérandes dans une rangée de la matrice, puis à appliquer le signal de commande à l'état passant du transistor sur les quatrièmes pistes conductrices des colonnes identifiées comme opérandes dans le mot de sélection d'opérandes.

Selon un mode de réalisation, le circuit de contrôle est en outre adapté à mettre en oeuvre une opération d'écriture verticale d'un mot dans une colonne de la matrice, comprenant :
l'application des bits à écrire sur les deuxièmes pistes conductrices des rangées contenant le mot à écrire ; et
l'application simultanée d'un signal d'écriture d'une première valeur binaire sur la première piste conductrice de la colonne contenant le mot à écrire.

Selon un mode de réalisation, le circuit de contrôle est en outre adapté, lors de la mise en oeuvre d'une opération d'écriture verticale, avant ou après l'étape d'application des bits à écrire sur les deuxièmes pistes conductrices des rangées contenant le mot à écrire et d'application simultanée d'un signal d'écriture d'une première valeur binaire sur la première piste conductrice de la colonne contenant le mot à écrire, à:
appliquer les bits complémentaires des bits à écrire sur les deuxièmes pistes conductrices des rangées contenant le mot à écrire ; et
appliquer simultanément un signal d'écriture d'une deuxième valeur binaire sur la première piste conductrice de la colonne contenant le mot à écrire.

Selon un mode de réalisation, chaque cellule élémentaire comporte en outre :
un deuxième noeud de stockage d'un bit de donnée complémentaire du bit stocké sur le premier noeud de stockage de la cellule ;
un quatrième transistor reliant le deuxième noeud de stockage à une cinquième piste conductrice et ayant sa grille reliée à la deuxième piste conductrice ; et
des cinquième et sixième transistors reliés en série entre un deuxième noeud d'application d'un potentiel de référence et une sixième piste conductrice, la grille du cinquième transistor étant reliée au deuxième noeud de stockage et la grille du sixième transistor étant reliée à une septième piste conductrice,
les cellules élémentaires d'une même rangées étant reliées par leurs sixièmes pistes conductrices et les cellules d'une même colonne étant reliées par leurs cinquièmes et sixièmes pistes conductrices.

Selon un mode de réalisation, dans chaque cellule élémentaire, les troisième et sixième pistes conductrices sont confondues.

Selon un mode de réalisation, dans chaque cellule élémentaire, les troisième et sixième pistes conductrices sont distinctes.

Selon un mode de réalisation, le circuit de contrôle est adapté, lors de la mise en oeuvre d'une opération logique à plusieurs opérandes stockés dans des colonnes distinctes, à :
appliquer simultanément un signal de commande à l'état passant du troisième transistor sur les quatrièmes pistes conductrices des colonnes contenant les opérandes et un signal de commande à l'état passant du sixième transistor sur les septièmes pistes conductrices des colonnes contenant les opérandes ; et
lire sur les troisièmes pistes conductrices des rangées contenant les opérandes, les bits du résultat de l'opération logique, et lire sur les sixièmes pistes conductrices des rangées contenant les opérandes, les bits du résultat de l'opération logique complémentée.

Selon un mode de réalisation, chaque cellule élémentaire comporte en outre un septième transistor reliant le premier noeud de stockage à une huitième piste conductrice et ayant sa grille reliée à une neuvième piste conductrice, et les cellules élémentaires d'une même rangée sont reliées par leurs neuvièmes pistes conductrices et les cellules élémentaires d'une même colonne sont reliées par leurs huitièmes pistes conductrices.

Selon un mode de réalisation, le circuit de contrôle est adapté, lors de la mise en oeuvre d'une opération d'écriture verticale d'un mot dans une colonne de la matrice, à :
appliquer les bits à écrire sur les deuxièmes pistes conductrices des rangées contenant le mot à écrire et appliquer les bits complémentaires des bits à écrire sur les neuvièmes pistes conductrices des rangées contenant le mot à écrire ; et
appliquer simultanément un signal d'écriture d'une première valeur binaire sur la première piste conductrice de la colonne contenant le mot à écrire et un signal d'écriture d'une deuxième valeur binaire sur la huitième piste conductrice de la colonne contenant le mot à écrire.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique détaillé d'un exemple d'une cellule élémentaire d'un circuit mémoire selon un mode de réalisation ;
la figure 2 est un schéma électrique simplifié d'un exemple d'un circuit mémoire selon un mode de réalisation ;
la figure 3 est une représentation simplifiée du circuit mémoire de la figure 2, illustrant un exemple d'agencement des données dans la matrice de cellules élémentaires du circuit ;
la figure 4 représente de façon schématique un autre exemple de réalisation d'un circuit mémoire ;
la figure 5 représente de façon schématique une variante de réalisation du circuit mémoire de la figure 4 ;
la figure 6 représente de façon schématique une autre variante de réalisation du circuit mémoire de la figure 4 ;
la figure 7 est un schéma électrique détaillé d'un autre exemple de réalisation d'une cellule élémentaire d'un circuit mémoire selon un mode de réalisation ; et
la figure 8 est un schéma électrique détaillé d'un autre exemple de réalisation d'une cellule élémentaire d'un circuit mémoire selon un mode de réalisation.

### Description détaillée

De mêmes éléments ont été désignés par de mêmes références dans les différentes figures. Par souci de clarté, seuls les éléments utiles à la compréhension des modes de réalisation décrits ont été représentés et sont détaillés. Dans la description qui suit, les références à des signaux de niveau haut et bas doivent être interprétées de façon relative, comme correspondant à deux états distincts des signaux binaires traités par les circuits décrits. A titre d'exemple, les signaux de niveau haut correspondent à des potentiels de l'ordre d'un potentiel d'alimentation haut VDD des circuits décrits (par exemple égal à VDD à 0,5 V près), et les signaux de niveau bas correspondent à des potentiels de l'ordre d'un potentiel d'alimentation bas GND des circuits décrits (par exemple égal à GND à 0,5 V près).

Selon un aspect d'un mode de réalisation, on prévoit un circuit mémoire adapté non seulement à stocker des données, mais aussi à effectuer, in-situ, lors d'accès au contenu de la mémoire, un certain nombre d'opérations logiques et/ou arithmétiques ayant pour opérandes des données stockées dans le circuit. Les résultats des calculs peuvent être transmis à des circuits externes à la mémoire, et/ou être réécrits dans la mémoire sans transiter par des circuits externes à la mémoire, et notamment par un bus de données externe à la mémoire.

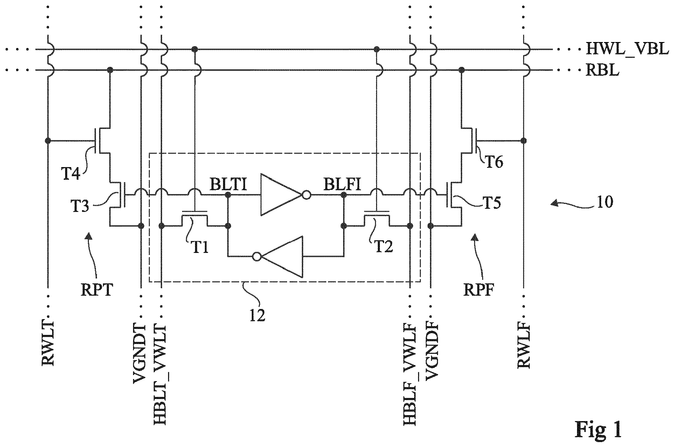

La figure 1 est un schéma électrique détaillé d'un exemple d'une cellule élémentaire 10 d'un circuit mémoire selon un mode de réalisation.

La cellule élémentaire 10 de la figure 1 est une cellule à dix transistors. Elle comprend une cellule de stockage SRAM 12 à six transistors, et deux ports de lecture RPT et RPF à deux transistors chacun. On notera toutefois que les modes de réalisation décrits peuvent être adaptés à d'autres types de cellules, et notamment à une cellule similaire à la cellule 10 mais comprenant un unique port de lecture, c'est-à-dire une cellule à huit transistors. La cellule de stockage 12 comprend deux inverseurs (deux transistors chacun) montés en antiparallèle entre un premier noeud BLTI de stockage d'un bit de donnée, et un deuxième noeud BLFI de stockage d'un bit de donnée complémentaire du bit stocké sur le noeud BLTI. La cellule de stockage 12 comprend en outre un premier transistor d'accès T1, reliant par ses noeuds de conduction le noeud BLTI à une piste conductrice HBLT VWLT, et un deuxième transistor d'accès T2, reliant par ses noeuds de conduction le noeud BLFI à une piste conductrice HBLF VWLF. Les grilles des transistors T1 et T2 sont reliées à une même piste conductrice HWL_VBL. Le port de lecture RPT comprend deux transistors T3 et T4 montés en série via leurs noeuds de conduction entre une piste conductrice VGNDT d'application d'un potentiel de référence et une piste conductrice RBL. Le transistor T3 est situé côté piste VGNDT et a sa grille reliée au noeud BLTI, et le transistor T4 est situé côté piste RBL et a sa grille reliée à une piste conductrice RWLT. Le port de lecture RPF comprend deux transistors T5 et T6 montés en série via leurs noeuds de conduction entre une piste conductrice VGNDF d'application d'un potentiel de référence et la piste conductrice RBL. Le transistor T5 est situé côté piste VGNDF et a sa grille reliée au noeud BLFI, et le transistor T6 est situé côté piste RBL et a sa grille reliée à une piste conductrice RWLF. Dans cet exemple, les transistors T1, T2, T3, T4, T5, T6 sont des transistors MOS à canal N.

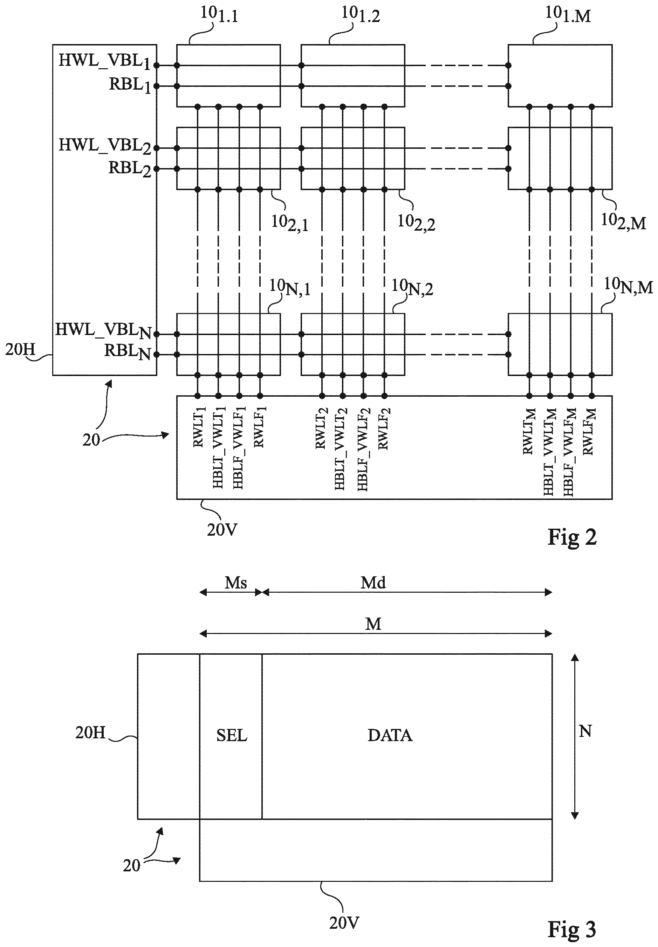

La figure 2 est un schéma électrique simplifié d'un exemple d'un circuit mémoire selon un mode de réalisation. Le circuit mémoire de la figure 2 comprend une pluralité de cellules élémentaires identiques ou similaires à la cellule 10 de la figure 1, agencées en matrice selon des rangées ayant une première direction (horizontale dans l'orientation de la figure 2) et des colonnes ayant une deuxième direction distincte de la première direction, par exemple orthogonale à la première direction (verticale dans l'orientation de la figure 2). Dans l'exemple de la figure 2, la matrice de cellules élémentaires comprend N rangées et M colonnes, où M et N sont des entiers supérieurs ou égaux à 2. Dans cet exemple, chaque cellule élémentaire de la matrice est désignée par la référence 10_{i,j}, où i est un entier allant de 1 à N désignant le rang de la rangée à laquelle appartient la cellule et j est un entier allant de 1 à M désignant le rang de la colonne à laquelle appartient la cellule.

Les cellules d'une même rangée sont interconnectées via leurs pistes conductrices HWL_VBL et via leurs pistes conductrices RBL, et les cellules d'une même colonne sont interconnectées via leurs pistes conductrices RWLT, via leurs pistes conductrices VGNDT, via leurs pistes conductrices HBLT VWLT, via leurs pistes conductrices HBLF_VWLF, via leurs pistes conductrices VGNDF, et via leurs pistes conductrices RWLF. En d'autres termes, les cellules d'une même rangée partagent une même piste conductrice HWL_VBL et une même piste conductrice RBL, et les cellules d'une même colonne partagent une même piste conductrice RWLT, une même piste conductrice VGNDT, une même piste conductrice HBLT_VWLT, une même piste conductrice HBLF_VWLF, une même piste conductrice VGNDF, et une même piste conductrice RWLF. Les cellules de rangées distinctes ont quant à elles des pistes conductrices HWL_VBL, respectivement RBL, distinctes, et les cellules de colonnes distinctes ont des pistes conductrices RWLT, respectivement VGNDT, respectivement HBLT_VWLT, respectivement HBLF_VWLF, respectivement VGNDF, respectivement RWLF, distinctes. Par souci de simplification, les pistes conductrices VGNDT et VGNDF n'ont pas été représentées sur la figure 2. A titre d'exemple, les pistes conductrices VGNDT et VGNDF sont toutes connectées à un même noeud d'application d'un potentiel de référence du circuit mémoire, par exemple la masse. Dans cet exemple, pour chaque rangée de rang i de la matrice, on désigne par HWL_VBLᵢ, respectivement RBLᵢ, la piste conductrice HWL_VBL, respectivement RBL, partagée par les cellules de la rangée, et, pour chaque colonne de rang j de la matrice, on désigne par RWLTⱼ, respectivement HBLT_VWLTⱼ, respectivement HBLF_VWLFⱼ, respectivement RWLFⱼ, la piste conductrice RWLT, respectivement HBLT_VWLT, respectivement HBLF_VWLF, respectivement RWLF partagée par les cellules de la colonne.

Le circuit mémoire de la figure 2 comprend de plus un circuit de contrôle ou circuit de sélection 20 comprenant un circuit de contrôle (ou de sélection) de rangée 20H et un circuit de contrôle (ou de sélection) de colonne 20V. Le circuit de contrôle de rangée 20H est connecté aux pistes conductrices HWL_VBLᵢ et RBLᵢ de la matrice et est adapté à contrôler ou lire de façon individuelle les signaux électriques appliqués sur les pistes conductrices HWL_VBLᵢ et RBLᵢ. Le circuit de contrôle de colonne 20V est connecté aux pistes conductrices RWLTⱼ, HBLT_VWLTⱼ, HBLF_VWLFⱼ et RWLFⱼ de la matrice et est adapté à contrôler ou lire de façon individuelle les signaux électrique appliqués sur les pistes conductrices RWLTⱼ, HBLT_VWLTⱼ, HBLF_VWLFⱼ et RWLFⱼ.

Différentes phases de fonctionnement du circuit mémoire de la figure 2, mises en oeuvre par le circuit de contrôle 20 de la mémoire, vont maintenant être décrites. Plus particulièrement, on va décrire ci-après le fonctionnement du circuit mémoire lors d'une phase d'écriture, lors d'une phase de lecture verticale, c'est-à-dire une phase de lecture d'une colonne ou d'une portion de colonne de la matrice de cellules, lors d'une phase de lecture horizontale, c'est-à-dire une phase de lecture d'une rangée ou d'une portion de rangée de la matrice de cellules, et lors d'une phase de mise en oeuvre d'une opération de calcul logique.

### Ecriture verticale

Lors d'une opération d'écriture verticale d'un mot de donnée (c'est-à-dire une suite de plusieurs bits) dans la mémoire, le mot est écrit selon une orientation verticale, c'est-à-dire dans le sens des colonnes, dans la matrice de cellules. Autrement dit, les différents bits du mot sont écrits dans différentes cellules d'une même colonne de la matrice.

Le circuit de contrôle 20 comprend un décodeur d'adresse de colonne adapté à recevoir l'adresse de la colonne à écrire, par exemple codée sur log₂(M) bits, et à activer en écriture la colonne correspondante.

L'opération d'écriture verticale est réalisée en deux cycles successifs d'un signal d'horloge appliqué au circuit de contrôle. Lors du premier cycle, les bits du mot à écrire ayant une première valeur binaire, par exemple la valeur '0', sont d'abord écrits dans la colonne adressée, puis, lors du deuxième cycle, les bits du mot à écrire ayant la deuxième valeur binaire, par exemple la valeur binaire '1', sont écrits dans la colonne adressée.

On considère ici, à titre d'exemple, une opération d'écriture verticale portant sur un mot de N bits, où N est le nombre de rangées de la matrice.

Lors du premier cycle, les N bits du mot de donnée d'entrée sont appliqués par le circuit de contrôle respectivement sur les pistes conductrices HWL_VBL₁, HWL_VBL₂, ... HWL_VBL_{N} de la matrice de cellules. Autrement dit, pour chaque bit du mot d'entrée, la piste conductrice HWL_VBLᵢ correspondante est mise à un potentiel de niveau haut (ce qui conduit à fermer les transistors T1 et T2) lorsque le bit a la valeur binaire '1' et à un potentiel de niveau bas (ce qui conduit à ouvrir les transistors T1 et T2) lorsque le bit a la valeur binaire '0'. De plus, lors du premier cycle, le circuit de contrôle de colonne 20V applique un potentiel de niveau haut sur la piste conductrice HBLT_VWLTⱼ de la colonne adressée et un potentiel de niveau bas sur la piste conductrice HBLF_VWLFⱼ de cette même colonne. Ainsi, la valeur binaire '1' est écrite dans toutes les cellules de la colonne pour lesquelles la piste conductrice HWL_VBLᵢ correspondante est à l'état haut (transistors T1 et T2 passants). Les valeurs des cellules de la colonne pour lesquelles la piste conductrice HWL_VBLᵢ est à l'état bas sont en revanche inchangées (transistors T1 et T2 bloqués).

Lors du deuxième cycle, les N bits complémentaires du mot de donnée d'entrée sont appliqués par le circuit de contrôle de rangée respectivement sur les pistes conductrices HWL_VBL₁ HWL_VBL₂, ... HWL_VBL_{N} de la matrice de cellules. Autrement dit, pour chaque bit du mot d'entrée, la piste conductrice HWL_VBLᵢ correspondante est mise à un potentiel de niveau bas lorsque le bit a la valeur binaire '1' et à un potentiel de niveau haut lorsque le bit a la valeur binaire '0'. De plus, lors du deuxième cycle, le circuit de contrôle applique un potentiel de niveau bas sur la piste conductrice HBLT_VWLT de la colonne adressée et un potentiel de niveau haut sur la piste conductrice HBLF_VWLF de cette même colonne. Ainsi, la valeur binaire '0' est écrite dans toutes les cellules de la colonne pour lesquelles la piste conductrice HWL_VBLᵢ correspondante est à l'état haut. Les valeurs des cellules de la colonne pour lesquelles la piste conductrice HWL_VBLᵢ est à l'état bas sont en revanche inchangées.

Pendant les deux cycles de l'opération d'écriture, toutes les colonnes de la matrice autres que la colonne adressée sont désactivées en écriture pour ne pas écraser les données qu'elles contiennent. Pour cela, dans chacune des colonnes de la matrice autres que la colonne adressée, les pistes conductrices HBLT_VWLTⱼ et HBLF_VWLFⱼ sont maintenues à un même niveau de potentiel, par exemple un potentiel de niveau haut, pendant les deux cycles de l'opération d'écriture. Ceci conduit à se placer dans les mêmes conditions de polarisation que lors d'une opération de lecture dans une cellule SRAM classique à six transistors.

On notera qu'une opération d'écriture d'un mot vertical de dimension inférieure à N peut être réalisée de façon similaire à ce qui vient d'être décrit. Pour cela, les pistes conductrices HWL_VBLᵢ des rangées que l'on ne souhaite pas écrire sont maintenues à un niveau bas pendant les deux cycles de l'opération d'écriture, de façon à maintenir les transistors T1 et T2 bloqués dans les cellules correspondantes.

### Lecture verticale

Lors d'une opération de lecture verticale, le circuit de contrôle lit dans la mémoire un mot de données orienté verticalement, c'est-à-dire dans le sens des colonnes de la matrice de cellules. Autrement dit, tous les bits du mot sont lus dans une même colonne de la matrice.

Le circuit de contrôle 20 comprend un décodeur d'adresse de colonne adapté à recevoir l'adresse de la colonne à lire, par exemple codée sur log₂(M) bits, et à activer en lecture la colonne correspondante. L'opération de lecture verticale est réalisée en un seul cycle d'horloge.

On considère ici, à titre d'exemple, une opération de lecture portant sur un mot de N bits, où N est le nombre de rangées de la matrice.

Avant l'opération de lecture verticale proprement dite, toutes les pistes conductrices RBLᵢ de la matrice sont d'abord préchargées à un potentiel de niveau haut, puis laissées flottantes. Pendant le cycle de lecture verticale, chacune des cellules de la colonne adressée a son port de lecture RPF activé et son port de lecture RPT désactivé. Autrement dit, dans chacune des cellules de la colonne adressée, le transistor T6 est fermé (passant) et le transistor T4 est ouvert (bloqué). Pour cela, dans cet exemple, un potentiel de niveau haut est appliqué sur la piste conductrice RWLFⱼ de la colonne adressée, et un potentiel de niveau bas est appliqué sur la piste conductrice RWLTⱼ de cette même colonne. Dans toutes les autres colonnes de la matrice, les ports de lecture RPT et RPF sont désactivés. Pour cela, dans cet exemple, dans chacune des colonnes autres que la colonne adressée, les pistes conductrices RWLFⱼ et RWLTⱼ sont mises à un potentiel de niveau bas. Dans chacune des cellules de la colonne adressée contenant la valeur binaire '0', le noeud BLFI est à un potentiel de niveau haut, de sorte que le transistor T5 est conducteur. Le transistor T6 étant également conducteur, la piste conductrice RBLᵢ correspondante se décharge. Au contraire, dans toutes les cellules de la colonne adressée contenant la valeur binaire '1', le noeud BLFI est à un potentiel de niveau bas, de sorte que le transistor T5 reste bloqué. La piste conductrice RBLᵢ correspondante ne se décharge donc pas.

Le circuit de contrôle est adapté à lire les N bits du mot de donnée sur les pistes conductrices de sortie RBL₁ à RBL_{N} de la matrice. Plus particulièrement, pour chaque bit du mot adressé, la piste conductrice RBLᵢ correspondante est à un potentiel de niveau relativement haut si le bit de donnée a la valeur binaire '1', et à un potentiel de niveau relativement bas si le bit de donnée a la valeur binaire '0'.

A titre de variante, pour lire la valeur complémentée du mot stocké dans la colonne adressée, le circuit de contrôle peut être configuré pour, au lieu d'activer les ports RPF et de désactiver les ports RPT des cellules de la colonne adressée, activer les ports RPT et désactiver les ports RPF de la colonne adressée.

Bien entendu, une opération de lecture complémentée ou non complémentée d'un mot vertical de dimension inférieure à N peut être réalisée de façon similaire à ce qui vient d'être décrit. Pour cela, le circuit de contrôle est configuré pour lire uniquement une partie des pistes conductrices RBLᵢ correspondant à la portion de colonne dans laquelle est stocké le mot que l'on souhaite lire.

### Lecture horizontale

Lors d'une opération de lecture horizontale, le circuit de contrôle lit dans la mémoire un mot de données orienté horizontalement, c'est-à-dire dans le sens des rangées de la matrice de cellules. Autrement dit, tous les bits du mot sont lus dans une même rangée de la matrice.

Le circuit de contrôle 20 comprend un décodeur d'adresse de rangée adapté à recevoir l'adresse de la rangée à lire, par exemple codée sur log₂(N) bits, et à activer en lecture la rangée correspondante. L'opération de lecture horizontale est réalisée en un seul cycle d'horloge.

On considère ici, à titre d'exemple, une opération de lecture portant sur un mot de M bits, où M est le nombre de colonnes de la matrice.

Pendant le cycle de lecture horizontale, la piste conductrice HWL_VBLᵢ de la rangée adressée est mise à un potentiel de niveau haut de façon à rendre passants les transistors T1 et T2 des cellules de la rangée. Les pistes conductrices HWL_VBLᵢ des autres rangées de la matrice sont mises à un potentiel de niveau bas de façon à bloquer les transistors T1 et T2 des cellules de ces rangées. Les M bits de la rangée sélectionnée sont alors lus par le circuit de contrôle, par exemple par lecture différentielle, respectivement sur les M paires de pistes conductrices HBLT_VWLT₁, HBLF_VWLF₁ à HBLT_VWLT_{M}, HBLF_VWLF_{M}.

Bien entendu, une opération de lecture d'un mot horizontal de dimension inférieure à M peut être réalisée de façon similaire à ce qui vient d'être décrit. Pour cela, le circuit de contrôle est configuré pour lire uniquement une partie des paires de pistes conductrices HBLT_VWLTⱼ, HBLF_VWLFⱼ correspondant aux colonnes de la matrice dans lesquelles est stocké le mot horizontal que l'on souhaite lire.

### Calcul logique

Pour réaliser une opération de calcul logique, le circuit de contrôle 20 commence par lire dans la mémoire un vecteur de sélection d'opérandes sous la forme d'un mot horizontal, c'est-à-dire un mot stocké dans une rangée unique de la matrice de cellules. La lecture du vecteur de sélection d'opérandes est réalisée en un cycle d'horloge selon le procédé de lecture horizontale décrit ci-dessus. L'adresse de la rangée contenant le vecteur de sélection d'opérandes peut être une adresse prédéterminée mémorisée dans le circuit de contrôle de la mémoire, ou une adresse fournie au circuit de contrôle de la mémoire par un dispositif de commande extérieur. Le vecteur de sélection d'opérandes comprend par exemple un nombre de bits égal au nombre de colonnes que comprend la matrice de cellules élémentaires, soit M bits dans cet exemple. A titre de variante, le vecteur de sélection d'opérandes peut comprendre un nombre de bits inférieur à M. A l'issue du cycle de lecture horizontale, le vecteur de sélection d'opérandes est par exemple mémorisé dans un registre de stockage temporaire du circuit de contrôle.

Dans un deuxième temps, le vecteur de sélection d'opérandes est utilisé comme masque de sélection pour activer simultanément en lecture verticale une pluralité de colonnes de la matrice. A titre d'exemple, pour chaque bit du vecteur de sélection d'opérandes, la colonne correspondante de la matrice est activée en lecture verticale si le bit correspondant du vecteur de sélection d'opérandes est à la valeur binaire '1', et n'est pas activée en lecture verticale si le bit correspondant du vecteur de sélection d'opérandes est à la valeur binaire '0'.

Comme indiqué précédemment, une colonne est activée en lecture verticale lorsque ses pistes conductrices RWLTⱼ et RWLFⱼ sont respectivement à un potentiel de niveau bas et à un potentiel de niveau haut (cas d'une lecture verticale non complémenté), ou respectivement à un potentiel de niveau haut et à un potentiel de niveau haut (cas d'une lecture verticale complémentée). La donnée contenue dans la colonne est alors lue sur les pistes conductrices de RBL₁ à RBL_{N}. Une colonne non activée en lecture verticale a quant à elle ses deux pistes conductrices RWLTⱼ et RWLFⱼ à un potentiel de niveau bas.

A titre d'exemple illustratif, on considère que deux colonnes de rang j et j+1 sont activées simultanément en lecture verticale non complémentée. Pour cela, après avoir préchargé à un potentiel de niveau haut les pistes conductrices RBLᵢ de la matrice, les ports d'accès RPF des cellules des colonnes de rang j et j+1 sont simultanément activés, les ports d'accès RPT desdites cellules et les ports d'accès RPT et RPF de toutes les autres cellules de la matrice étant maintenus inactifs. Autrement dit, les transistors de sélection T6 des cellules des colonnes de rang j et j+1 sont simultanément rendus passants, les transistors de sélection T4 desdites cellules et les transistors de sélection T4 et T6 de toutes les autres cellules de la matrice étant maintenus bloqués.

Pour chaque rangée de rang i de la matrice, si l'on désigne par A la valeur binaire mémorisée sur le noeud BLTI de la cellule 10_{i,j} et par B la valeur binaire mémorisée sur le noeud BLTI de la cellule 10_{i,j+1}. La cellule 10_{i,j} stocke alors sur son noeud BLFI le complémentaire *A̅* de la valeur A, et la cellule 10_{i,j+1} stocke sur son noeud BLFI le complémentaire B̅ de la valeur B. La piste conductrice de sortie RBLᵢ de la rangée reste à son niveau haut de précharge uniquement si les deux valeurs A et B sont à un niveau haut. Le niveau lu sur la piste de sortie RBLT de la colonne à la fin de l'opération de lecture correspond donc au résultat A.B d'une opération de calcul logique ET entre les deux cellules sélectionnées de la rangée. Ainsi, la valeur lue par le circuit de contrôle sur les pistes conductrices RBL₁ à RBL_{N} de la matrice correspond au résultat de l'opération logique ET entre un mot vertical stocké dans la colonne de rang j et un mot vertical stocké dans la colonne de rang j+1.

En activant simultanément en lecture verticale non complémentée un nombre supérieur à deux de colonnes de la matrice, la même opération logique ET est réalisée mais avec un nombre d'opérandes supérieur à deux.

En activant simultanément plusieurs colonnes en lecture verticale complémentée, on réalise de façon similaire une opération de calcul logique NON OU entre les mots stockés dans les colonnes activées.

Ainsi, une opération de calcul logique ET ou NON OU peut être réalisée en deux cycles d'horloge, un premier cycle pour lire le mot de sélection d'opérandes par lecture horizontale d'une rangée de la matrice, et un deuxième cycle pour activer en lecture verticale les colonnes identifiées comme opérandes dans le mot de sélection d'opérandes. Si la lecture verticale est réalisée via le port RPF (lecture non complémentée), l'opération réalisée est un ET logique. Si la lecture verticale est réalisée via le port RPT (lecture complémentée), l'opération logique réalisée est un NON OU logique. A noter que si l'on prévoit de charger le mot de sélection d'opérandes depuis l'extérieur du circuit, l'opération de calcul logique ET ou NON OU peut être réalisée en un seul cycle. Dans cet exemple, si l'on souhaite réaliser les deux opérations logiques ET et NON OU, trois cycles d'horloge sont nécessaires, un premier cycle pour lire le mot de sélection d'opérandes, un deuxième cycle pour activer en lecture verticale non complémentée les colonnes identifiées comme opérandes dans le mot de sélection d'opérandes, puis un troisième cycle pour activer en lecture verticale complémentée les colonnes identifiées comme opérandes dans le mot de sélection d'opérandes (ou deux cycles si l'on prévoit de charger le mot de sélection d'opérandes depuis l'extérieur du circuit).

Un avantage du circuit mémoire décrit en relation avec les figures 1 et 2 est qu'il permet de mettre en oeuvre des opérations logiques de base directement dans la mémoire, sans avoir à faire transiter les données par une unité arithmétique et logique externe au circuit.

De plus, quel que soit le nombre K d'opérandes de l'opération de calcul, l'adressage des données opérandes est réalisé de façon simple, au moyen d'un mot de sélection d'opérandes préalablement mémorisé dans la matrice et pouvant être lu en un seul cycle d'horloge selon le procédé de lecture horizontale susmentionné. En particulier, le circuit mémoire décrit ci-dessus permet avantageusement de réaliser une opération de calcul logique à K opérandes sans avoir à effectivement décoder les K adresses des opérandes au moyen d'un décodeur d'adresse.

Le résultat de l'opération de calcul logique peut être transmis à des circuits externes à la mémoire, et/ou être réécrit dans la mémoire sans transiter par des circuits externes à la mémoire, et notamment par un bus de données externe à la mémoire.

Pour permettre la réécriture du résultat d'une opération logique sans faire transiter la donnée calculée par des circuits externes à la mémoire, et notamment par un bus de données externe à la mémoire, le circuit de contrôle de la mémoire peut en outre comprendre un registre de stockage temporaire, non détaillé, permettant de stocker le résultat de l'opération de calcul lu sur les pistes conductrices de sortie RBLᵢ, en vue de sa réécriture dans une colonne de la matrice selon le procédé d'écriture verticale susmentionné ou selon un procédé de lecture horizontale.

La figure 3 est une représentation simplifiée du circuit mémoire de la figure 2, illustrant un exemple possible d'agencement des données opérandes et des données de sélection d'opérandes dans la matrice de cellules élémentaires.

Comme décrit précédemment, le circuit mémoire de la figure 3 comprend une matrice de N rangées par M colonnes de cellules élémentaires. Dans l'exemple de la figure 3, les données de sélection d'opérandes sont stockées sous la forme de mots horizontaux dans une première sous-matrice SEL de N rangées par Ms colonnes, où Ms est un entier inférieur à M, et les données opérandes sont stockées sous la forme de mots verticaux dans une deuxième sous matrice DATA de N rangées par Md colonnes distincte de la première sous-matrice, où Md est un entier inférieur à M tel que Md+Ms=M. A titre de variante, les données de sélection d'opérandes sont stockées sous la forme de mots verticaux dans la sous-matrice SEL et les données opérandes sont stockées sous la forme de mots horizontaux dans la sous matrice DATA.

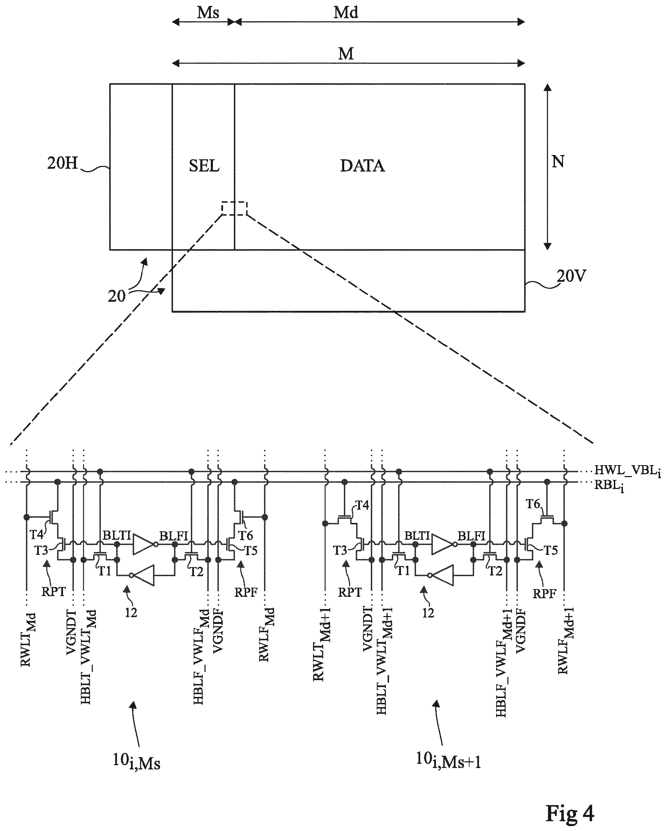

La figure 4 illustre une variante de réalisation du circuit mémoire de la figure 3, dans laquelle les cellules élémentaires de la sous-matrice SEL de stockage des données de sélection d'opérandes, et les cellules élémentaires de la sous-matrice DATA de stockage des données opérandes sont de natures différentes. Plus particulièrement, dans l'exemple de la figure 4, la sous-matrice SEL est constituée de cellules élémentaires identiques aux cellules 10 décrites en relation avec la figure 1, et la sous-matrice DATA est constituée de cellules élémentaires différentes des cellules 10 de la figure 1.

La figure 4 représente un agrandissement d'une portion d'une rangée de rang i de la matrice, située à la jonction entre les sous-matrices SEL et DATA. Plus particulièrement, la portion de rangée représentée sur la figure 4 comprend deux cellules élémentaires consécutives 10_{i,Ms} et 10_{i,Ms+1}, la cellule 10ᵢ,_{Ms} étant la dernière cellule de la rangée appartenant à la sous-matrice SEL, et la cellule 10_{i,Ms+1} étant la première cellule de la rangée appartenant à la sous-matrice DATA.

Comme l'illustre la figure 4, les cellules élémentaires de la sous-matrice SEL sont identiques à la cellule 10 de la figure 1, et sont interconnectées en matrice selon des rangées et des colonnes selon un agencement identique ou similaire à ce qui a été décrit en relation avec la figure 2.

Les cellules élémentaires de la sous-matrice DATA diffèrent des cellules élémentaires de la sous-matrice SEL essentiellement en ce que, dans chaque cellule élémentaire 10_{i,j} de la sous-matrice DATA :
- les transistors T3 et T4 du port de lecture RPT de la cellule sont connectés en série, via leurs noeuds de conduction, entre la piste conductrice VGNDT et la piste conductrice RWLT de la cellule, le transistor T4 étant situé côté piste RWLT et ayant sa grille reliée à la piste conductrice RBL de la cellule ; et
- les transistors T5 et T6 du port de lecture RPF de la cellule sont connectés en série, via leurs noeuds de conduction, entre la piste conductrice VGNDF et la piste conductrice RWLF de la cellule, le transistor T6 étant situé côté piste RWLF et ayant sa grille reliée à la piste conductrice RBL de la cellule.

Les cellules élémentaires de la sous-matrice DATA sont interconnectées en matrice selon des rangées et des colonnes selon un agencement identique ou similaire à ce qui a été décrit en relation avec la figure 2.

Dans l'exemple de la figure 4, les sous-matrices SEL et DATA sont directement connectées. Plus particulièrement, dans chaque rangée de rang i du circuit mémoire, les cellules élémentaires 10_{i,1} à 10_{i,Ms}, appartenant à la sous-matrice SEL, et les cellules élémentaires 10_{i,Ms+1} à 10_{i,M}, appartenant à la sous-matrice DATA, partagent la même piste conductrice RBLᵢ et la même piste conductrice HWL_VBLᵢ.

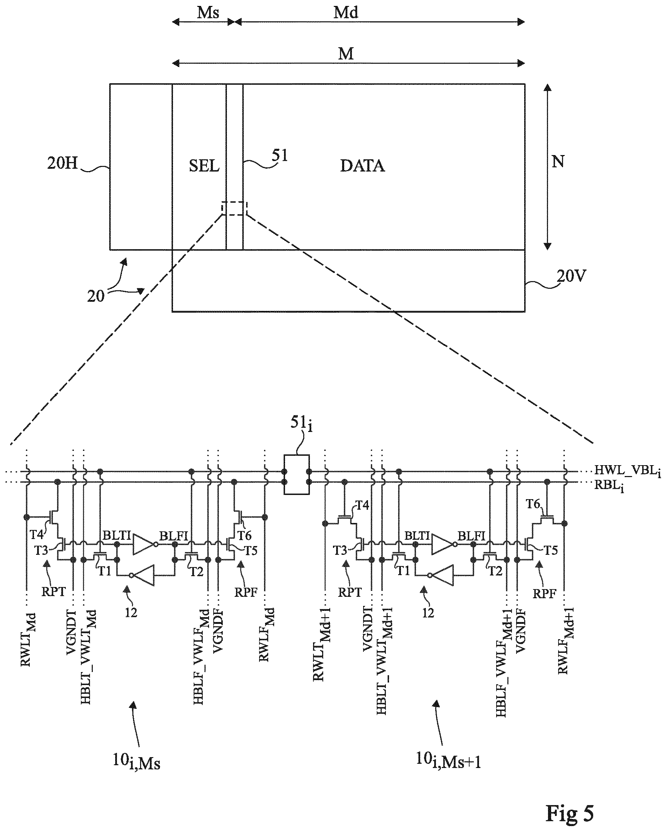

La figure 5 illustre une variante de réalisation du circuit mémoire de la figure 4. Le circuit mémoire de la figure 5 diffère du circuit mémoire de la figure 4 en ce que, dans l'exemple de la figure 5, les sous-matrices SEL et DATA ne sont pas directement connectées entre elles, mais sont reliées l'une à l'autre par un circuit d'interface 51. Plus particulièrement, dans l'exemple de la figure 5, dans chaque rangée de rang i de la matrice, un circuit d'interface 51ᵢ relie d'une part la piste conductrice HWL_VBLᵢ de la rangée de rang i de la sous-matrice SEL à la piste conductrice HWL_VBLᵢ de la rangée de rang i de la sous-matrice DATA, et d'autre part la piste conductrice RBLᵢ de la rangée de rang i de la sous-matrice SEL à la piste conductrice RBLᵢ de la rangée de rang i de la sous-matrice DATA. A titre d'exemple, le circuit d'interface 51ᵢ comprend un buffer et/ou un inverseur reliant la piste conductrice HWL_VBLᵢ de la rangée de rang i de la sous-matrice SEL à la piste conductrice HWL_VBLᵢ de la rangée de rang i de la sous-matrice DATA, et un buffer et/ou un inverseur reliant la piste conductrice RBLᵢ de la rangée de rang i de la sous-matrice SEL à la piste conductrice RBLᵢ de la rangée de rang i de la sous-matrice DATA.

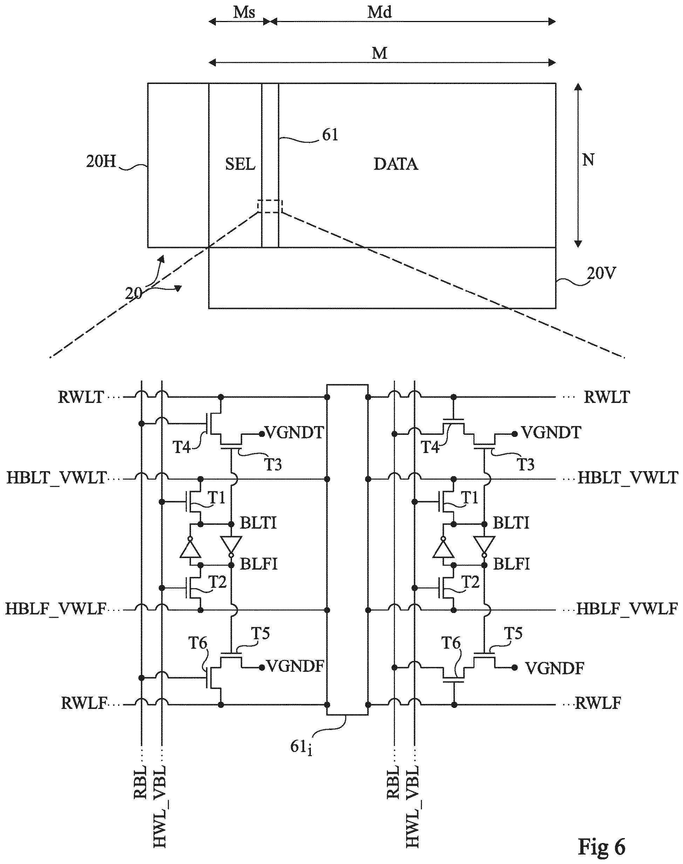

La figure 6 illustre une autre variante de réalisation du circuit mémoire de la figure 3 dans laquelle les cellules élémentaires de la sous-matrice SEL de stockage des données de sélection d'opérandes et les cellules élémentaires de la sous-matrice DATA de stockage des données opérandes sont de natures différentes.

Dans l'exemple de la figure 6, la sous-matrice DATA est constituée de cellules élémentaires identiques aux cellules 10 décrites en relation avec la figure 1. Toutefois, le schéma d'interconnexion des cellules est différent de ce qui a été décrit en relation avec la figure 2. Plus particulièrement, dans l'exemple de la figure 6, les cellules élémentaires d'une même rangée de la sous-matrice DATA sont interconnectées via leurs pistes conductrices RWLT, respectivement HBLT_VWLT, respectivement HBLF_VWLF, respectivement RWLF, et les cellules élémentaires d'une même colonne de la sous-matrice DATA sont interconnectées via leurs pistes conductrices RBL, respectivement HWL_VBL.

De plus, dans l'exemple de la figure 6, la sous-matrice SEL est constituée de cellules élémentaires du même type que les cellules élémentaires de la sous-matrice DATA du circuit mémoire de la figure 4. Toutefois, le schéma d'interconnexion des cellules est différent de ce qui a été décrit précédemment. Plus particulièrement, dans l'exemple de la figure 6, les cellules élémentaires d'une même rangée de la sous-matrice SEL sont interconnectées via leurs pistes conductrices RWLT, respectivement HBLT_VWLT, respectivement HBLF_VWLF, respectivement RWLF, et les cellules d'une même colonne de la sous-matrice SEL sont interconnectées via leurs pistes conductrices RBL, respectivement HWL_VBL.

Dans l'exemple de la figure 6, les sous-matrices SEL et DATA sont reliées l'une à l'autre par un circuit d'interface 61. Plus particulièrement, dans l'exemple de la figure 6, dans chaque rangée de rang i de la matrice, un circuit d'interface 61ᵢ relie la piste conductrice RWLT de la rangée de rang i de la sous-matrice SEL à la piste conductrice RWLT de la rangée de rang i de la sous-matrice DATA, la piste conductrice HBLT VWLT de la rangée de rang i de la sous-matrice SEL à la piste conductrice HBLT_VWLT de la rangée de rang i de la sous-matrice DATA, la piste conductrice HBLF_VWLF de la rangée de rang i de la sous-matrice SEL à la piste conductrice HBLF_VWLF de la rangée de rang i de la sous-matrice DATA, et la piste conductrice RWLF de la rangée de rang i de la sous-matrice SEL à la piste conductrice RWLF de la rangée de rang i de la sous-matrice DATA. A titre d'exemple, le circuit d'interface 61ᵢ comprend un buffer et/ou un inverseur reliant la piste conductrice RWLT de la rangée de rang i de la sous-matrice SEL à la piste conductrice RWLT de la rangée de rang i de la sous-matrice DATA, un buffer et/ou un inverseur reliant la piste conductrice HBLT_VWLT de la rangée de rang i de la sous-matrice SEL à la piste conductrice HBLT_VWLT de la rangée de rang i de la sous-matrice DATA, un buffer et/ou un inverseur reliant la piste conductrice HBLF_VWLF de la rangée de rang i de la sous-matrice SEL à la piste conductrice HBLF_VWLF de la rangée de rang i de la sous-matrice DATA, et un buffer et/ou un inverseur reliant la piste conductrice RWLF de la rangée de rang i de la sous-matrice SEL à la piste conductrice RWLF de la rangée de rang i de la sous-matrice DATA.

La configuration de la figure 6 est notamment avantageuse dans le cas où le nombre N de rangées du circuit mémoire est relativement faible devant le nombre M de colonnes, dans la mesure où la dimension des cellules élémentaires dans la direction des colonnes est plus importante que dans la direction des rangées. Ainsi, le circuit mémoire dans son ensemble aura un facteur de forme moins allongé/rectangulaire, permettant une meilleure implémentation et un meilleur accès/connexion au niveau système.

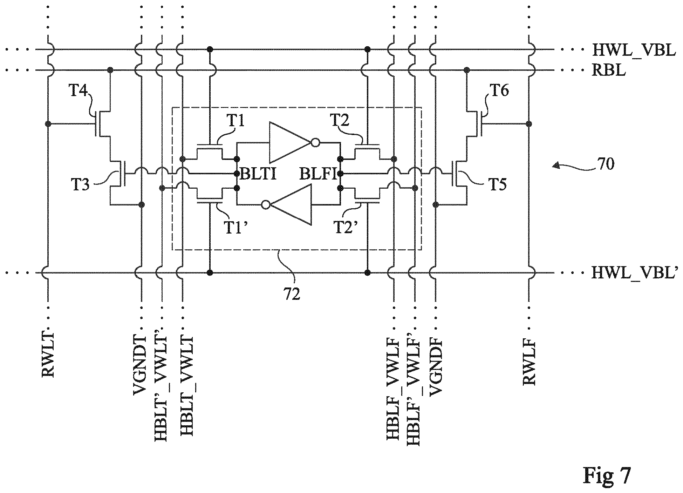

La figure 7 est un schéma électrique détaillé d'un autre exemple de réalisation d'une cellule élémentaire 70 d'un circuit mémoire selon un mode de réalisation. La cellule élémentaire 70 de la figure 7 diffère de la cellule élémentaire 10 de la figure 1 en ce que, dans la cellule élémentaire 70, la cellule de stockage SRAM 12 à six transistors de la figure 1 a été remplacée par une cellule de stockage SRAM 72 à huit transistors. La cellule de stockage SRAM 72 comprend les mêmes éléments que la cellule 12 de la figure 1, agencés sensiblement de la même manière, et comprend en outre un premier transistor d'accès supplémentaire T1' reliant par ses noeuds de conduction le noeud BLTI à une première piste conductrice supplémentaire HBLT_VWLT', et un deuxième transistor d'accès supplémentaire T2', reliant par ses noeuds de conduction le noeud BLFI à une deuxième piste conductrice supplémentaire HBLF_VWLF'. Les grilles des transistors T1' et T2' sont reliées à une même troisième piste conductrice supplémentaire HWL_VBL'. Dans cet exemple, les transistors supplémentaires T1' et T2' sont des transistors MOS à canal N.

Un circuit mémoire selon un mode de réalisation peut comporter une pluralité de cellules élémentaires 70 du type décrit en relation avec la figure 7, agencées en matrice selon des rangées et des colonnes de façon similaire à ce qui a été décrit en relation avec la figure 2. Dans ce cas, en plus des interconnexions déjà décrites en relation avec la figure 2, les cellules élémentaires sont interconnectées en rangées via les pistes conductrices supplémentaires HWL_VBL' et en colonnes via les pistes conductrices supplémentaires HBLT_VWLT' et HBLF_VWLF'.

Un avantage de cette configuration est qu'elle permet de réaliser une opération d'écriture d'un mot vertical en un seul cycle d'horloge au lieu de deux dans l'exemple décrit en relation avec les figures 1 et 2.

Pour cela, lors de l'opération d'écriture, les bits du mot à écrire sont appliqués par le circuit de contrôle respectivement sur les pistes conductrices HWL _VBL₁, HWL_VBL₂, ... HWL_VBL_{N} de la matrice de cellules (dans le cas d'une écriture d'un mot de N bits). Autrement dit, pour chaque bit du mot d'entrée, la piste conductrice HWL_VBLᵢ correspondante est mise à un potentiel de niveau haut lorsque le bit a la valeur binaire '1' et à un potentiel de niveau bas lorsque le bit a la valeur binaire '0'.

Les bits complémentaires du mot à écrire sont en outre simultanément appliqués sur les pistes conductrices HWL_VBL'₁, HWL_VBL'₂, ... HWL_VBL'_{N} de la matrice de cellules. Autrement dit, pour chaque bit du mot d'entrée, la piste conductrice HWL_VBL'ᵢ correspondante est mise à un potentiel de niveau haut lorsque le bit à écrire dans la cellule sélectionnée a la valeur binaire '0' et à un potentiel de niveau bas lorsque le bit a la valeur binaire '1'.

De plus, lors de l'opération d'écriture, le circuit de contrôle applique :
un potentiel de niveau haut sur la piste conductrice HBLT_VWLT de la colonne adressée et un potentiel de niveau bas sur la piste conductrice HBLF_VWLF de cette même colonne ; et
un potentiel de niveau bas sur la piste conductrice HBLT_VWLT' de la colonne adressée et un potentiel de niveau haut sur la piste conductrice HBLF VWLF' de cette même colonne.

Ainsi, la valeur binaire '1' est écrite dans toutes les cellules de la colonne pour lesquelles les pistes conductrices HWL_VBLᵢ et HWL_VBL'ᵢ correspondantes sont respectivement à l'état haut et à l'état bas (transistors T1 et T2 passants et transistors T1' et T2' bloqués), et la valeur binaire '0' est écrite dans toutes les cellules de la colonne pour lesquelles les pistes conductrices HWL_VBLᵢ et HWL_VBL'ᵢ sont respectivement à l'état bas et à l'état haut (transistors T1 et T2 bloqués et transistors T1' et T2' passants).

Pendant l'opération d'écriture, toutes les colonnes de la matrice autres que la colonne adressée sont désactivées en écriture pour ne pas écraser les données qu'elles contiennent. Pour cela, dans chacune des colonnes de la matrice autres que la colonne adressée, les pistes conductrices HBLT_VWLTⱼ et HBLF_VWLFⱼ d'une part, et HBLT_VWLT'ⱼ et HBLF_VWLF'j d'autre part, sont maintenues à un même niveau de potentiel, par exemple un potentiel de niveau haut, correspondant à un cas de lecture conventionnelle (qui conserve donc l'information stockée).

Pour réaliser une opération d'écriture d'un mot vertical de dimension inférieure à N, les pistes conductrices HWL_VBLᵢ et HWL_VBL'ᵢ des rangées que l'on ne souhaite pas écrire sont maintenues à un niveau bas pendant l'opération d'écriture, de façon à maintenir les transistors T1, T2, T1' et T2' bloqués dans les cellules correspondantes.

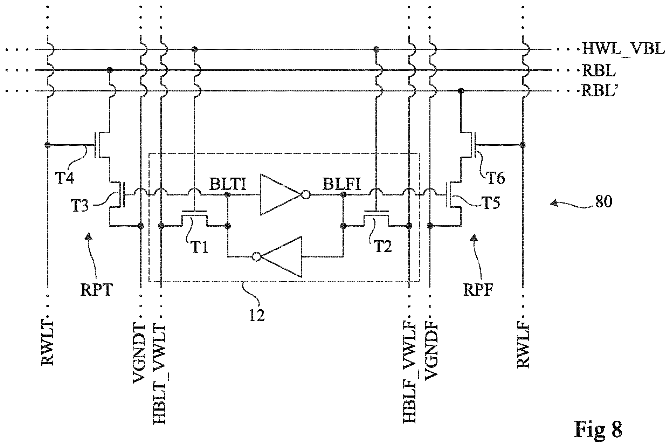

La figure 8 est un schéma électrique détaillé d'un autre exemple de réalisation d'une cellule élémentaire 80 d'un circuit mémoire selon un mode de réalisation. La cellule élémentaire 80 de la figure 8 comprend les mêmes éléments que la cellule élémentaire 10 de la figure 1, et comprend en outre une piste conductrice supplémentaire RBL'. Dans la cellule élémentaire 80 de la figure 8, les deux transistors T3 et T4 du port de lecture RPT sont, comme dans l'exemple de la figure 1, connectés en série via leurs noeuds de conduction entre la piste conductrice VGNDT et la piste conductrice RBL. La cellule élémentaire 80 de la figure 8 diffère de la cellule élémentaire 10 de la figure 1 en ce que, dans la cellule 80, les transistors T5 et T6 sont connectés en série non pas entre la piste conductrice VGNDF et la piste conductrice RBL, mais entre la piste conductrice VGNDF et la piste conductrice RBL'.

Un circuit mémoire selon un mode de réalisation peut comporter une pluralité de cellules élémentaires 80 du type décrit en relation avec la figure 8, agencées en matrice selon des rangées et des colonnes de façon similaire à ce qui a été décrit en relation avec la figure 2. Dans ce cas, en plus des interconnexions déjà décrites en relation avec la figure 2, les cellules élémentaires sont interconnectées en rangées via les pistes conductrices supplémentaires RBL'.

Un avantage de cette configuration est qu'elle permet de réaliser une lecture verticale complémentée et une lecture verticale non complémentée en un même cycle d'horloge. De plus, cette configuration permet de réaliser les opérations de calcul logique ET et NON OU en un même cycle d'horloge.

Pour réaliser une opération de lecture verticale, le circuit de contrôle active simultanément les ports de lecture RPT et RPF de toutes les cellules de la colonne adressée. Pour cela, dans cet exemple, le circuit de contrôle applique simultanément un potentiel de niveau haut sur les pistes conductrices RWLT et RWLF de la colonne adressée. Dans toutes les autres colonnes de la matrice, les ports de lecture RPT et RPF sont désactivés. Au préalable, toutes les pistes conductrices RBLᵢ et RBL'ᵢ de la matrice ont été préchargées à un potentiel de niveau haut.

Le circuit de contrôle est adapté à lire les bits du mot de donnée sur les pistes conductrices de sortie RBLᵢ de la matrice, et les bits complémentaires du mot de donnée sur les pistes conductrices de sortie RBL'ᵢ de la matrice.

Pour réaliser une opération de calcul logique, le circuit de contrôle 20 commence, comme dans l'exemple décrit en relation avec les figures 1 et 2, par lire dans la mémoire un vecteur de sélection d'opérandes sous la forme d'un mot horizontal.

Dans un deuxième temps, le vecteur de sélection d'opérandes est utilisé comme masque de sélection pour activer simultanément en lecture verticale une pluralité de colonnes de la matrice. Dans l'exemple de la figure 8, le circuit de contrôle active simultanément les ports de lecture RPT et RPF des cellules de chaque colonne activée. Pour cela, le circuit de contrôle applique simultanément un potentiel de niveau haut sur les deux pistes conductrices RWLT et RWLF de chaque colonne activée. Les ports de lecture RPT et RPF des colonnes non sélectionnées sont en revanche maintenus inactifs (transistors T4 et T6 bloqués).

Le circuit de contrôle est adapté à lire les bits du résultat de l'opération logique ET sur les pistes conductrices RBLᵢ de la matrice, et les bits du résultat de l'opération logique NON OU sur les pistes conductrices RBL'ᵢ de la matrice.

Des modes de réalisation particuliers ont été décrits. Diverses variantes et modifications apparaîtront à l'homme de l'art. En particulier, les modes de réalisation décrits ne se limitent pas aux exemples particuliers décrits ci-dessus dans lesquels les transistors des cellules élémentaires du circuit mémoire sont tous des transistors MOS à canal N. A titre de variante, d'autres types de transistors peuvent être utilisés, par exemple des transistors MOS à canal P. L'homme du métier saura alors adapter en conséquence les niveaux des signaux de commande appliqués aux cellules pour obtenir le fonctionnement recherché.

De plus, les modes de réalisation décrits ne se limitent pas aux exemples particuliers décrits ci-dessus dans lesquels chaque cellule élémentaire du circuit mémoire comprend deux ports d'accès. L'homme du métier saura adapter les modes de réalisation décrits à des cellules élémentaires comportant un unique port d'accès. A titre d'exemple, en se référant à la figure 1, les transistors T2, T5 et T6 et les pistes conductrices HBLF_VWLF, VGNDF et RWLF peuvent être omis. De façon similaire, en se référant à la figure 7, les transistors T2 et T2', T5 et T6 et les pistes conductrices HBLF_VWLF, HBLF_VWLF', VGNDF et RWLF peuvent être omis.

En outre, les modes de réalisation décrits ne se limitent pas aux exemples décrits ci-dessus dans lesquels les cellules élémentaires du circuit mémoire sont des cellules de type SRAM. Plus généralement, les modes de réalisation décrits peuvent s'appliquer à d'autres technologies de cellules, par exemple des cellules de type ReRAM (mémoire résistive non volatile) ou des cellules de type DRAM (mémoire dynamique capacitive).

A titre d'exemple, pour réaliser un circuit mémoire de type ReRAM, on peut prévoir, dans les cellules 12 (figures 1 et 8) et 72 (figure 7) des exemples décrits ci-dessus, de remplacer l'association en antiparallèle de deux inverseurs par une association en série de deux éléments résistifs à résistance programmable, une première extrémité de ladite association en série étant reliée à un noeud d'application d'un potentiel d'alimentation haut de la cellule, la deuxième extrémité de ladite association en série étant reliée à un noeud d'application d'un potentiel d'alimentation bas de la cellule, et le noeud intermédiaire de ladite association en série, ou point milieu entre les deux éléments résistifs, formant le noeud de stockage BLTI de la cellule.

A titre de variante, pour réaliser un circuit mémoire de type DRAM, on peut prévoir, dans les cellules 12 (figures 1 et 8) et 72 (figure 7) des exemples décrits ci-dessus, de remplacer l'association en antiparallèle de deux inverseurs par un élément capacitif ayant une première électrode reliée, par exemple connectée, au noeud BLTI, et une deuxième électrode reliée, par exemple connectée, à un noeud d'application d'un potentiel de référence de la cellule.

Par ailleurs, divers modes de réalisation avec diverses variantes ont été décrits ci-dessus. L'homme du métier pourra combiner divers éléments de ces divers modes de réalisation et variantes sans faire preuve d'activité inventive. En particulier, les variantes de réalisation des figures 7 et 8 peuvent être combinées.

## Revendications

1. Circuit mémoire comportant une pluralité de cellules élémentaires (10, 70, 80) agencées en matrice selon des rangées et des colonnes et un circuit de contrôle (20),
dans lequel chaque cellule élémentaire comporte :
un premier noeud (BLTI) de stockage d'un bit de donnée ;
un premier transistor (T1) reliant le premier noeud de stockage (BLTI) à une première piste conductrice (HBLT_VWLT) et ayant sa grille reliée à une deuxième piste conductrice (HWL_VBL) ; et
des deuxième (T3) et troisième (T4) transistors reliés en série entre un premier noeud (VGNDT) d'application d'un potentiel de référence et une troisième piste conductrice (RBL), la grille du deuxième transistor (T3) étant reliée au premier noeud de stockage (BLTI) et la grille du troisième transistor (T4) étant reliée à une quatrième piste conductrice (RWLT),
dans lequel les cellules élémentaires d'une même rangée partagent une même deuxième piste conductrice (HWL_VBL)et une même troisième piste conductrice (RBL) et les cellules d'une même colonne partagent une même première piste conductrice (HBLT_VWLT) et une même quatrième piste conductrice (RWLT),
et dans lequel le circuit de contrôle (20) est adapté à mettre en oeuvre une opération de lecture verticale d'un mot dans une colonne de la matrice, comprenant :
l'application d'un signal de commande à l'état passant du troisième transistor (T4) sur la quatrième piste conductrice (RWLT) de la colonne contenant le mot à lire ; et
la lecture des bits du mot sur les troisièmes pistes conductrices (RBL) des rangées contenant le mot à lire,
**caractérisé en ce que** le circuit de contrôle (20) est en outre adapté à mettre en oeuvre une opération de lecture horizontale d'un mot dans une rangée de la matrice, comprenant :
l'application d'un signal de commande à l'état passant du premier transistor (T1) sur la deuxième piste conductrice (HWL_VBL)de la rangée contenant le mot à lire ; et
la lecture des bits du mot sur les premières pistes conductrices (HBLT VWLT) des colonnes contenant le mot à lire.

2. Circuit mémoire selon la revendication 1, dans lequel le circuit de contrôle (20) est en outre adapté à mettre en oeuvre une opération logique à plusieurs opérandes stockés dans des colonnes distinctes, comprenant :
l'application simultanée d'un signal de commande à l'état passant du troisième transistor (T4) sur les quatrièmes pistes conductrices (RWLT) des colonnes contenant les opérandes ;
la lecture, sur les troisièmes pistes conductrices (RBL) des rangées contenant les opérandes, des bits du résultat de l'opération logique.

3. Circuit mémoire selon la revendication 2, dans lequel le circuit de contrôle (20) est adapté, lors de la mise en oeuvre de l'opération logique, à réaliser une opération initiale de lecture horizontale d'un mot de sélection d'opérandes dans une rangée de la matrice, puis à appliquer le signal de commande à l'état passant du transistor (T4) sur les quatrièmes pistes conductrices (RWLT) des colonnes identifiées comme opérandes dans le mot de sélection d'opérandes.

4. Circuit mémoire selon l'une quelconque des revendications 1 à 3, dans lequel le circuit de contrôle (20) est en outre adapté à mettre en oeuvre une opération d'écriture verticale d'un mot dans une colonne de la matrice, comprenant :
l'application des bits à écrire sur les deuxièmes pistes conductrices (HWL_VBL) des rangées contenant le mot à écrire ; et
l'application simultanée d'un signal d'écriture d'une première valeur binaire sur la première piste conductrice (HBLT VWLT) de la colonne contenant le mot à écrire.

5. Circuit mémoire selon la revendication 4, dans lequel le circuit de contrôle (20) est en outre adapté, lors de la mise en oeuvre d'une opération d'écriture verticale, avant ou après l'étape d'application des bits à écrire sur les deuxièmes pistes conductrices (HWL_VBL) des rangées contenant le mot à écrire et d'application simultanée du signal d'écriture de la première valeur binaire sur la première piste conductrice (HBLT_VWLT) de la colonne contenant le mot à écrire, à :
appliquer les bits complémentaires des bits à écrire sur les deuxièmes pistes conductrices (HWL_VBL) des rangées contenant le mot à écrire ; et
appliquer simultanément un signal d'écriture d'une deuxième valeur binaire sur la première piste conductrice (HBLT_VWLT) de la colonne contenant le mot à écrire.

6. Circuit mémoire selon l'une quelconque des revendications 1 à 5, dans lequel chaque cellule élémentaire comporte en outre :
un deuxième noeud (BLFI) de stockage d'un bit de donnée complémentaire du bit stocké sur le premier noeud de stockage (BLTI) de la cellule ;
un quatrième transistor (T2) reliant le deuxième noeud de stockage (BLFI) à une cinquième piste conductrice (HBLF VWLF) et ayant sa grille reliée à la deuxième piste conductrice (HWL_VBL) ; et
des cinquième (T5) et sixième (T6) transistors reliés en série entre un deuxième noeud (VGNDF) d'application d'un potentiel de référence et une sixième piste conductrice (RBL ; RBL'), la grille du cinquième transistor (T5) étant reliée au deuxième noeud de stockage (BLFI) et la grille du sixième transistor (T6) étant reliée à une septième piste conductrice (RWLT),
dans lequel les cellules élémentaires d'une même rangée partagent une même sixième piste conductrice (RBL, RBL') et les cellules d'une même colonne partagent une même cinquième piste conductrice (HBLF VWLF) et une même septième piste conductrice (RWLF) .

7. Circuit mémoire selon la revendication 6, dans lequel, dans chaque cellule élémentaire (10 ; 70), les troisième (RBL) et sixième (RBL) pistes conductrices sont confondues.

8. Circuit mémoire selon la revendication 6, dans lequel, dans chaque cellule élémentaire (80), les troisième (RBL) et sixième (RBL') pistes conductrices sont distinctes.

9. Circuit mémoire selon la revendication 8 dans son rattachement à la revendication 2, dans lequel le circuit de contrôle (20) est adapté, lors de la mise en oeuvre d'une opération logique à plusieurs opérandes stockés dans des colonnes distinctes, à :
appliquer simultanément un signal de commande à l'état passant du troisième transistor (T4) sur les quatrièmes pistes conductrices (RWLT) des colonnes contenant les opérandes et un signal de commande à l'état passant du sixième transistor (T6) sur les septièmes pistes conductrices (RWLF) des colonnes contenant les opérandes ; et
lire sur les troisièmes pistes conductrices (RBL) des rangées contenant les opérandes, les bits du résultat de l'opération logique, et lire sur les sixièmes pistes conductrices (RBL') des rangées contenant les opérandes, les bits du résultat de l'opération logique complémentée.

10. Circuit mémoire selon l'une quelconque des revendications 1 à 9, dans lequel chaque cellule élémentaire (70) comporte en outre un septième transistor (T1') reliant le premier noeud de stockage (BLTI) à une huitième piste conductrice (HBLT_VWLT') et ayant sa grille reliée à une neuvième piste conductrice (HWL_VBL'), et dans lequel les cellules élémentaires d'une même rangée partagent une même neuvième piste conductrice (HWL_VBL') et les cellules élémentaires d'une même colonne partagent une même huitième piste conductrice (HBLT_VWLT').

11. Circuit mémoire selon la revendication 10 dans son rattachement à la revendication 4, dans lequel le circuit de contrôle (20) est adapté, lors de la mise en oeuvre d'une opération d'écriture verticale d'un mot dans une colonne de la matrice, à :
appliquer les bits à écrire sur les deuxièmes pistes conductrices (HWL_VBL) des rangées contenant le mot à écrire et appliquer les bits complémentaires des bits à écrire sur les neuvièmes pistes conductrices (HWL VBL') des rangées contenant le mot à écrire ; et
appliquer simultanément un signal d'écriture d'une première valeur binaire sur la première piste conductrice (HBLT VWLT) de la colonne contenant le mot à écrire et un signal d'écriture d'une deuxième valeur binaire sur la huitième piste conductrice (HBLT_VWLT') de la colonne contenant le mot à écrire.

## Patentansprüche

1. Speicherschaltung mit einer Vielzahl von Elementarzellen (10, 70, 80), die in einer Matrix aus Zeilen und Spalten angeordnet sind, und einer Steuerschaltung (20),
wobei jede Elementarzelle Folgendes aufweist:
einen ersten Datenbit-Speicherknoten (BLTI)
einen ersten Transistor (T1), der den ersten Speicherknoten (BLTI) mit einer ersten Leiterbahn (HBLT_VWLT) koppelt und dessen Gate mit einer zweiten Leiterbahn (HWL_VBL) gekoppelt ist; und
einen zweiten (T3) und einen dritten (T4) Transistor, die zwischen einem ersten Knoten (VGNDT) zum Anlegen eines Referenzpotentials und einer dritten Leiterbahn (RBL) in Reihe geschaltet sind, wobei das Gate des zweiten Transistors (T3) mit dem ersten Speicherknoten (BLTI) und das Gate des dritten Transistors (T4) mit einer vierten Leiterbahn (RWLT) gekoppelt ist,
wobei die Elementarzellen einer gleichen Zeile sich eine gleiche zweite Leiterbahn (HWL_VBL) und eine gleiche dritte Leiterbahn (RBL) teilen und die Zellen einer gleichen Spalte sich eine gleiche erste Leiterbahn (HBLT_VWLT) und eine gleiche vierte Leiterbahn (RWLT) teilen,
und wobei die Steuerschaltung (20) geeignet ist zum Implementieren einer Operation des vertikalen Lesens eines Wortes aus einer Spalte der Matrix, aufweisend:
Anlegen eines Signals zum Steuern des dritten Transistors (T4) in den Ein-Zustand an die vierte Leiterbahn (RWLT) der Spalte, die das zu lesende Wort enthält; und
Lesen der Bits des Wortes von den dritten Leiterbahnen (RBL) der Zeilen, die das zu lesende Wort enthalten,
**dadurch gekennzeichnet, dass** die Steuerschaltung (20) ferner geeignet ist zum Implementieren einer Operation des horizontalen Lesens eines Wortes aus einer Zeile der Matrix, aufweisend:
Anlegen eines Signals zum Steuern des ersten Transistors (T1) in den Ein-Zustand an die zweite Leiterbahn (HWL_VBL) der Zeile, die das zu lesende Wort enthält; und
Lesen der Bits des Wortes von den ersten Leiterbahnen (HBLT_VWLT) der Spalten, die das zu lesende Wort enthalten.

2. Speicherschaltung nach Anspruch 1, wobei die Steuerschaltung (20) ferner geeignet ist zum Implementieren einer logischen Operation mit einer Vielzahl von in unterschiedlichen Spalten gespeicherten Operanden, aufweisend:
gleichzeitiges Anlegen eines Signals zum Steuern des dritten Transistors (T4) in den Ein-Zustand an die vierten Leiterbahnen (RWLT) der Spalten, die die Operanden enthalten;
Lesen, von den dritten Leiterbahnen (RBL) der Zeilen, die die Operanden enthalten, der Bits des Ergebnisses der logischen Operation.

3. Speicherschaltung nach Anspruch 2, wobei die Steuerschaltung (20) geeignet ist, bei der Implementierung der logischen Operation, zum Durchführen eine anfängliche Operation des horizontalen Lesens eines Operanden-Auswahlwortes aus einer Zeile der Matrix und zum anschließenden Anlegen des Signals zum Steuern des Transistors (T4) in den Ein-Zustand an die vierten Leiterbahnen (RWLT) der Spalten, die als Operanden in dem Operanden-Auswahlwort identifiziert sind.

4. Speicherschaltung nach einem der Ansprüche 1 bis 3, wobei die Steuerschaltung (20) ferner geeignet ist zum Implementieren einer Operation des vertikalen Schreibens eines Wortes in eine Spalte der Matrix, aufweisend:
Anlegen der zu schreibenden Bits an die zweiten Leiterbahnen (HWL_VBL) der Zeilen, die das zu schreibende Wort enthalten; und
gleichzeitiges Anlegen eines ersten Binärwert-Schreibsignals an die erste Leiterbahn (HBLT_VWLT) der Spalte, die das zu schreibende Wort enthält.

5. Speicherschaltung nach Anspruch 4, wobei die Steuerschaltung (20) ferner in geeignet ist, bei der Implementierung einer vertikalen Schreiboperation vor oder nach den Schritten des Anlegens der zu schreibenden Bits an die zweite Leiterbahnen (HWL_VBL) der Zeilen, die das zu schreibende Wort enthalten, und des gleichzeitigen Anlegens des ersten Binärwert-Schreibsignals an die erste Leiterbahn (HBLT_VWLT) der Spalte, die das zu schreibende Wort enthält,
zum Anlegen der zu den zu schreibenden Bits komplementären Bits an die zweiten Leiterbahnen (HWL_VBL) der Zeilen, die das zu schreibende Wort enthalten; und
zum gleichzeitigen Anlegen eines zweiten Binärwert-Schreibsignals an die erste Leiterbahn (HBLT_VWLT) der Spalte, die das zu schreibende Wort enthält.

6. Speicherschaltung nach einem der Ansprüche 1 bis 5, wobei jede Elementarzelle ferner Folgendes aufweist:
einen zweiten Knoten (BLFI) zum Speichern eines Datenbits, das komplementär zu dem auf dem ersten Speicherknoten (BLTI) der Zelle gespeicherten Bit ist;
einen vierten Transistor (T2), der den zweiten Speicherknoten (BLFI) mit einer fünften Leiterbahn (HBLF_VWLF) koppelt und dessen Gate mit der zweiten Leiterbahn (HWL_VBL) gekoppelt ist; und
fünfte (T5) und einen sechste (T6) Transistoren, die zwischen einem zweiten Knoten (VGNDF) zum Anlegen eines Referenzpotentials und einer sechsten Leiterbahn (RBL; RBL') in Reihe geschaltet sind, wobei das Gate des fünften Transistors (T5) mit dem zweiten Speicherknoten (BLFI) und das Gate des sechsten Transistors (T6) mit einer siebten Leiterbahn (RWLT) gekoppelt ist,
wobei die Elementarzellen einer gleichen Zeile eine gleiche sechste Leiterbahn (RBL, RBL') und die Zellen einer gleichen Spalte eine gleiche fünfte Leiterbahn (HBLF_VWLF) und eine gleiche siebte Leiterbahn (RWLF) teilen.

7. Speicherschaltung nach Anspruch 6, wobei in jeder Elementarzelle (10; 70) die dritte (RBL) und die sechste (RBL) Leiterbahn zusammen sind.

8. Speicherschaltung nach Anspruch 6, wobei in jeder Elementarzelle (80) die dritte (RBL) und die sechste (RBL') Leiterbahn getrennt sind.

9. Speicherschaltung nach Anspruch 8 und nach Anspruch 2, wobei die Steuerschaltung (20) geeignet ist, bei der Implementierung einer logischen Operation mit einer Vielzahl von in verschiedenen Spalten gespeicherten Operanden, zum:
gleichzeitigen Anlegen eines Signals zum Steuern des dritten Transistors (T4) in den Ein-Zustand an die vierten Leiterbahnen (RWLT) der die Operanden enthaltenden Spalten und eines Signals zum Steuern des sechsten Transistors (T6) in den Ein-Zustand an die siebten Leiterbahnen (RWLF) der die Operanden enthaltenden Spalten; und
Lesen von den dritten Leiterbahnen (RBL) der Zeilen, die die Operanden enthalten, der Bits des Ergebnisses der logischen Operation und Lesen von den sechsten Leiterbahnen (RBL') der Zeilen, die die Operanden enthalten, der Bits des Ergebnisses der komplementären logischen Operation

10. Speicherschaltung nach einem der Ansprüche 1 bis 9, wobei jede Elementarzelle (70) ferner einen siebten Transistor (T1') aufweist, der den ersten Speicherknoten (BLTI) mit einer achten Leiterbahn (HBLT_VWLT') koppelt und dessen Gate mit einer neunten Leiterbahn (HWL_VBL') gekoppelt ist, und wobei die Elementarzellen einer gleichen Zeile sich eine gleiche neunte Leiterbahn (HWL_VBL') und die Elementarzellen einer gleichen Spalte sich eine gleiche achte Leiterbahn (HBLT_VWLT') teilen.

11. Speicherschaltung nach Anspruch 10 und nach Anspruch 4, wobei die Steuerschaltung (20) geeignet ist, bei der Durchführung einer Operation des vertikalen Schreibens eines Wortes in eine Spalte der Matrix, zum:
Anlegen der zu schreibenden Bits an die zweiten Leiterbahnen (HWL_VBL) der Zeilen, die das zu schreibende Wort enthalten, und Anlegen der zu den zu schreibenden Bits komplementären Bits an die neunten Leiterbahnen (HWL VBL') der Zeilen, die das zu schreibende Wort enthalten; und
gleichzeitiges Anlegen eines ersten Binärwert-Schreibsignals an die erste Leiterbahn (HBLT_VWLT) der Spalte, die das zu schreibende Wort enthält, und eines zweiten Binärwert-Schreibsignals an die achte Leiterbahn (HBLT_VWLT') der Spalte, die das zu schreibende Wort enthält.

## Claims

1. A memory circuit comprising a plurality of elementary cells (10, 70, 80) arranged in an array of rows and columns and a control circuit (20),
wherein each elementary cell comprises:
a first data bit storage node (BLTI);
a first transistor (T1) coupling the first storage node (BLTI) to a first conductive track (HBLT_VWLT) and having its gate coupled to a second conductive track (HWL_VBL); and
second (T3) and third (T4) transistors series-coupled between a first node (VGNDT) of application of a reference potential and a third conductive track (RBL), the gate of the second transistor (T3) being coupled to the first storage node (BLTI) and the gate of the third transistor (T4) being coupled to a fourth conductive track (RWLT),
wherein the elementary cells of a same row share a same second conductive track (HWL VBL) and a same third conductive track (RBL) and the cells of a same column share a same first conductive track (HBLT VWLT) and a same fourth conductive track (RWLT),
and wherein the control circuit (20) is capable of implementing an operation of vertical reading of a word from a column of the array, comprising:
applying a signal for controlling to the on state the third transistor (T4) to the fourth conductive track (RWLT) of the column containing the word to be read; and
reading the bits of the word from the third conductive tracks (RBL) of the rows containing the word to be read,
**characterized in that** the control circuit (20) is further capable of implementing an operation of horizontal reading of a word from a row of the array, comprising:
applying a signal for controlling to the on state the first transistor (T1) to the second conductive track (HWL_VBL) of the row containing the word to be read; and
reading the bits of the word from the first conductive tracks (HBLT_VWLT) of the columns containing the word to be read.

2. The memory circuit of claim 1, wherein the control circuit (20) is further capable of implementing a logic operation with a plurality of operands stored in different columns, comprising:
simultaneously applying a signal for controlling to the on state the third transistor (T4) to the fourth conductive tracks (RWLT) of the columns containing the operands;
reading from the third conductive tracks (RBL) of the rows containing the operands the bits of the result of the logic operation.

3. The memory circuit of claim 2, wherein the control circuit (20) is capable, on implementation of the logic operation, of performing an initial operation of horizontal reading of an operand selection word from a row of the array, and then of applying the signal for controlling to the on state the transistor (T4) to the fourth conductive tracks (RWLT) of the columns identified as operands in the operand selection word.

4. The memory circuit of any of claims 1 to 3, wherein the control circuit (20) is further capable of implementing an operation of vertical writing of a word into a column of the array, comprising:
applying the bits to be written to the second conductive tracks (HWL_VBL) of the rows containing the word to be written; and
simultaneously applying a first binary value writing signal to the first conductive track (HBLT_VWLT) of the column containing the word to be written.

5. The memory circuit of claim 4, wherein the control circuit (20) is further capable, on implementation of a vertical write operation, before or after the steps of application of the bits to be written to the second conductive tracks (HWL VBL) of the rows containing the word to be written and of simultaneous application of the first binary value writing signal to the first conductive track (HBLT VWLT) of the column containing the word to be written, of:
applying the bits complementary to the bits to be written to the second conductive tracks (HWL_VBL) of the rows containing the word to be written; and
simultaneously applying a second binary value writing signal to the first conductive track (HBLT VWLT) of the column containing the word to be written.

6. The memory circuit of any of claims 1 to 5, wherein each elementary cell further comprises:
a second node (BLFI) for storing a data bit complementary to the bit stored on the first storage node (BLTI) of the cell;
a fourth transistor (T2) coupling the second storage node (BLFI) to a fifth conductive track (HBLF_VWLF) and having its gate coupled to the second conductive track (HWL_VBL); and
fifth (T5) and sixth (T6) transistors series-coupled between a second node (VGNDF) of application of a reference potential and a sixth conductive track (RBL; RBL'), the gate of the fifth transistor (T5) being coupled to the second storage node (BLFI) and the gate of the sixth transistor (T6) being coupled to a seventh conductive track (RWLT),
wherein the elementary cells of a same row share a same sixth conductive track (RBL, RBL') and the cells of a same column share a same fifth conductive track (HBLF_VWLF) and a same seventh conductive track (RWLF).

7. The memory circuit of claim 6, wherein, in each elementary cell (10; 70), the third (RBL) and sixth (RBL) conductive tracks are confounded.

8. The memory circuit of claim 6, wherein, in each elementary cell (80), the third (RBL) and sixth (RBL') conductive tracks are distinct.

9. The memory circuit of claim 8 and of claim 2, wherein the control circuit (20) is capable, on implementation of a logic operation with a plurality of operands stored in different columns, of:
simultaneously applying a signal for controlling to the on state the third transistor (T4) to the fourth conductive tracks (RWLT) of the columns containing the operands and a signal for controlling to the on state the sixth transistor (T6) to the seventh conductive tracks (RWLF) of the columns containing the operands; and
reading from the third conductive tracks (RBL) of the rows containing the operands the bits of the result of the logic operation, and reading from the sixth conductive tracks (RBL') of the rows containing the operands the bits of the result of the complemented logic operation.

10. The memory circuit of any of claims 1 to 9, wherein each elementary cell (70) further comprises a seventh transistor (T1') coupling the first storage node (BLTI) to an eighth conductive track (HBLT VWLT') and having its gate coupled to a ninth conductive track (HWL VBL') and wherein the elementary cells of a same row share a same ninth conductive track (HWL VBL') and the elementary cells of a same column share a same eighth conductive track (HBLT_VWLT').

11. The memory circuit of claim 10 and of claim 4, wherein the control circuit (20) is capable, on implementation of an operation of vertical writing of a word into a column of the array, of:
applying the bits to be written to the second conductive tracks (HWL VBL) of the rows containing the word to be written and applying the bits complementary to the bits to be written to the ninth conductive tracks (HWL VBL') of the rows containing the word to be written; and
simultaneously applying a first binary value writing signal to the first conductive track (HBLT VWLT) of the column containing the word to be written and a second binary value writing signal to the eighth conductive track (HBLT_VWLT') of the column containing the word to be written.
